(19) Europäisches Patentamt
European Patent Office
Office européen des brevets

(11) Publication number: **0 580 880 A1**

(12) # EUROPEAN PATENT APPLICATION

(21) Application number: **92111538.2**

(51) Int. Cl.[5]: **H01L 21/306**, H01L 21/321

(22) Date of filing: **08.07.92**

(30) Priority: **30.07.91 US 737731**

(43) Date of publication of application: **02.02.94 Bulletin 94/05**

(84) Designated Contracting States: **DE FR GB**

(71) Applicant: **INTERNATIONAL BUSINESS MACHINES CORPORATION**
**Old Orchard Road**
**Armonk, N.Y. 10504(US)**

(72) Inventor: **Austin, Larry W.**
**RR2, Box 283**
**Hinesburg, VT 05461(US)**
Inventor: **Linde, Harold G.**
**HCR Box 188**
**Richmond, VT 05477(US)**

(74) Representative: **Mönig, Anton, Dipl.-Ing.**
**IBM Deutschland Informationssysteme GmbH,**
**Patentwesen und Urheberrecht**
**D-70548 Stuttgart (DE)**

(54) **Control of anisotropic silicon etching utilizing a selected catalyzed etchant.**

(57) An improved method for anisotropically etching the (100) crystallographic plane of silicon wafers involves immersing the wafers in an etching solution containing an aromatic compound having at least two adjacent hydroxyl groups and a polar functional group on the ring, an amine, water, and a substituted 1,4-diazine. The etching solution is effective at etching silicon at a rate in excess of about 100 microns per hour. A quality etch at rates up to about 150 microns per hour or greater and with a high degree of uniformity can be achieved.

EP 0 580 880 A1

This invention relates to the etching of silicon, and, more particularly, to the improved anisotropic etching of single crystal silicon at a rapid rate.

The anisotropic etching of single crystal silicon has been carried out for many years in the production of microelectronic devices. An essential feature is that the etching solutions etch the (100) crystallographic plane at an appreciably greater rate than the (110) and (111) planes, producing v-shaped sidewalls at 54.74° from the (100) surface. Exemplificative of the solutions which are known in the art are the following: IBM Tech. Discl. Bull., Vol. 19, No. 9 (Feb. 1977), p. 3623 discloses a solution for anisotropically etching single crystal silicon, containing ethylene diamine, pyrocatechol and water; and IBM Tech. Discl. Bull., Vol. 19, No. 10 (Mar. 1977), p. 3953 also describes such a solution, containing the three ingredients described in the preceding article, but further including hydrogen peroxide.

See also, U.S. Pat. Nos. 4,417,946, issued to Bohlen, et al. on Nov. 29, 1983, and 4,342,817, issued to Bohlen, et al. on Aug. 3, 1982, both of which disclose a method of making a mask, employing an etching solution consisting of ethylene diamine, pyrocatechol, water, and, optionally, hydrogen peroxide; and U.S. Pat. Nos. 4,293,373, issued to Greenwood on Oct. 6, 1981, and 4,229,979, issued to Greenwood on Oct. 28, 1980, both of which disclose a method of making a silicon transducer which involves etching a boron doped silicon wafer, with a solution containing ethylene diamine, pyrocatechol and water.

See also U.S. Pat. No. 4,155,866, issued to Berkenblit, et al. on May 22, 1979 and U.S. Pat. No. 4,187,140, issued to Berkenblit, et al. on Feb. 5, 1980, both of which disclose an etching solution for silicon, containing ethylene diamine, pyrocatechol, water and, as a catalyst, a diazine compound. Further, see Reisman, "Controlled Etching of Silicon", J. Electrochem. Soc., 126 (1979), p. 1406.

Note also, U.S. Pat. No. 3,650,957, issued to Shipley, Jr., et al. on Mar. 21, 1972, which discloses a solution for etching copper, which includes a source of cupric ions, a complexing agent for cupric ions, such as a hydroxy-carboxylic acid or an alkanolamine, a source of chloride or bromide ions and a solution soluble molybdenum, tungsten or vanadium compound.

U.S. Pat. No. 3,873,203, issued to Stevenson on Mar. 25, 1975, discloses a mixture for etching silicon, containing hydrazine and pyrocatechol.

Further, U.S. Pat. No. 3,160,539, issued to Hall, et al. on Dec. 8, 1964, relates to an etching solution for silicon, which includes piperidine.

IBM Tech. Discl. Bull., Vol. 15, No. 1 (June 1972), p. 173 discloses an etchant for aluminum, consisting of a solution of a secondary organic amine, such as piperidine or pyrrolidine, in water.

In addition, a particularly effective solution for etching single crystal silicon is disclosed in U.S. Pat. No. 4,929,301, issued to Beechko on May 29, 1990. That solution comprises ethanolamine, pyrocatechol, water, hydrogen peroxide and piperidine. It has been found that the solution etches (100) silicon at a rate of about 40 $\mu$/hr.

Another particularly effective solution is disclosed in U.S. Pat. No. 4,941,941, issued to Austin, et al. on Jul. 17, 1990. That solution contains a select aromatic compound, an amine and water.

Now, an improved method of etching silicon has been developed which involves contacting the silicon with an etching solution which comprises an aromatic compound having at least two adjacent hydroxyl groups and a polar functional group on the ring, an amine, water, and a catalytic amount of a substituted 1,4-diazine. The solution is effective in etching silicon at a rate in excess of about 100 microns per hour. The present invention is also directed to the etching solution per se. In accordance with the invention, an etch rate for (100) silicon of about 150 $\mu$/hr. or greater has been achieved. Moreover, the etching solution is relatively safe in manufacturing use and environmentally compatible with current disposal techniques.

In the practice of the invention, silicon bodies, e.g. wafers, to be etched are preferably immersed in the etching solution. Preferably, this is carried out at a temperature of greater than about 80°C to reflux, more preferably greater than about 100°C to reflux, and most preferably at reflux. The actual temperature and time may vary, however, depending upon a number of factors, such as the desired etch rate, the geometry being etched, the exact formulation employed, and so forth, as will be apparent to those skilled in the art. In addition, the pH of the solution preferably ranges from about 10.5 - 11.5 in most situations.

As noted above, the etching solution employed according to the present invention includes an aromatic compound having at least two adjacent hydroxyl groups and a polar functional group on the ring. Typically, the polar functional group is COOH, $SO_2OH$ or $NO_2$, with COOH being preferred. Suitable aromatic compounds include, for example, the following:

1,2-dihydroxybenzene-3,5-disulfonic acid;
6,7-dihydroxy-2-naphthalenesulfonic acid;
3,4-dihydroxybenzoic acid;
2,3-dihydroxybenzoic acid;
2,3,4-trihydroxybenzoic acid;

4-nitrocatechol; and

esculetin (6,7-dihydroxycoumarin).

In a particularly preferred embodiment, the aromatic compound is gallic acid.

Any suitable amine compound with a relatively high polarity may be employed in the etching solution of the invention. Suitable amines include, for example, the following:

a. The primary aliphatic amines including mono-, di-, and triamines. These amines usually contain 2-8, and preferably 2-6, carbon atoms such as ethylamine, n-propylamine, n-butylamine, n-amylamine, n-hexylamine, ethylene diamine, diaminopropane, diaminobutane, pentamethylene diamine, m-xylylenediamine and diethylene triamine. Particularly preferred amines in this group are the diamines having 2-4 carbon atoms such as ethylene diamine and diaminopropane.

b. The alkanolamines, i.e., the aliphatic hydroxy amines. Usually each alkanol group in these amines contains from 2 to 5 carbon atoms. Illustrative are monoethanolamine, diethanolamine, triethanolamine, the mono-, di-, and tripropanolamines, ethanolpropanolamine, diethanolpropanolamine, and the mono-, di-, and tributanolamines. Particularly preferred alkanolamines are those in which each alkanol group contains 2-3 carbon atoms such as the ethanolamines, the propanolamines and the ethanolpropanolamines.

In a particularly preferred embodiment of the invention, monoethanolamine is employed.

Although the proportions of the ingredients may vary over wide ranges, the etching solution preferably contains about 3-6 mole percent of the aromatic compound, about 32-56 mole percent of the amine and about 65-38 mole percent of water.

In accordance with the invention, a catalytic amount of a substituted 1,4-diazine is added to control the etch rate of the solution. It is a discovery of the invention, that a catalytic amount of a substituted 1,4-diazine can be employed to achieve an etch rate in excess of about 100 microns per hour. Indeed, according to the invention, an etch rate of about 150 microns per hour or greater can be obtained, the specific etch rate depending upon the exact catalyst used, the amount, the temperature of the solution, and so forth.

In general, the substituted 1,4-diazine is used in an amount greater than about 0.01 mole percent of the solution. Preferably, the etching solution contains about 0.01 to about 0.15 mole percent, and more preferably about 0.03 to about 0.13 mole percent, of the substituted 1,4-diazine.

The substituted 1,4-diazine employed in accordance with the invention generally includes at least one substituent which is a bulky group which provides steric hindrance. Preferably, the bulky group is larger than methyl, such as carboxyl or carboxamide or a fused aromatic ring.

Preferably, the substituted 1,4-diazine is un-symmetrical, i.e. with substituents attached to the 2-or 2- and 3- positions of the 1,4-diazine ring. Preferred compounds include those having the formulas:

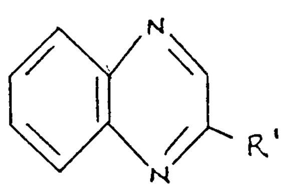

where $R^1$ is hydrogen, hydroxyl or alkyl, preferably $C_1$-$C_4$ alkyl;

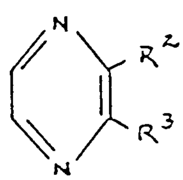

where $R^2$ is carboxyl or substituted carboxyl, preferably carboxamide or carboxester, and $R^3$ is hydrogen, carboxyl or substituted carboxyl, preferably carboxamide or carboxester; or

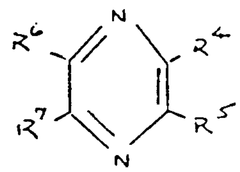

where $R_4$, $R_5$, $R_6$ and $R_7$ are independently selected from hydrogen or alkyl, preferably $C_1$-$C_4$ alkyl, where $R_4$, $R_5$, $R_6$ and $R_7$ cannot all be H.

A particularly preferred group of substituted 1,4-diazines includes quinoxaline, 2-quinoxalinol, pyrazinamide, 2,3-pyrazinedicarboxamide, 2-pyrazine- carboxylic acid, 2,3-pyrazinedicarboxylic acid and tetramethylpyrazine.

Various other ingredients may be added to the etching solution. For example, a small amount of hydrogen peroxide (e.g., 0.5 - 3 ml/1000 ml of amine compound) may be added, which may further enhance the etch rate of the solution. In addition, a small amount of a surfactant (e.g., 0.5 - 3 ml/1000 ml of amine compound), such as "FC-129", commercially available from Minnesota Mining & Manufacturing Company, or other fluorinated hydrocarbon surfactants, may be added. The presence of surfactant is desirable because it provides an increase in uniformity of etching, apparently by inhibiting adhesion of evolving hydrogen bubbles at the etching surface.

The etching solution of the invention provides a quality etch, i.e. with minimal pits, hillocks and faceting, at a very rapid rate and to a high degree of uniformity. As such, it is desirable for use in a number of applications. For example, the etching solution can also be used in the manner described in U.S. Pat. No. 4,342,817.

In one preferred application, the etching solution can be used to etch (100) silicon at a high rate (about 150 $\mu$/hr.), while stopping at highly doped boron interfaces, allowing production of large, thin boron-rich windows on the surface of thick silicon wafers. These silicon products are useful in the manufacture of x-ray and e-beam masks.

Besides etching single crystal silicon, the etching solution of the invention is also effective in etching other silicon, such as polycrystalline silicon or epitaxial silicon.

The following examples are provided to illustrate the invention.

EXAMPLES 1-6 AND COMPARATIVE EXAMPLES A-K

A 10 liter reaction vessel with magnetic stir bar was charged with 1150 g of gallic acid, 1600 ml of deionized water, 3650 ml of ethanolamine, 25 g of catalyst, and 3 ml of surfactant (10% of "FC-129", a commercial product of 3M Corp.). The stirred mixture was heated to reflux under a water condenser. Silicon wafers having a (100) crystallographic orientation were etched by immersing the wafers in the stirred, refluxing etching solution using a PTFE wafer boat. The etch rates of these wafers, determined by weight loss, were as shown in Table I below.

TABLE I

| Example (No.) or Comparative Example (Letter) | Catalyst | Etching Rate (μ/hr.) | Comments |
|---|---|---|---|
| 1 | Quinoxaline | 150 | Smoothest |
| 2 | Pyrazinamide | 132 | Good Smooth |
| 3 | 2,3-Pyrazine-dicarboxamide | 132 | Good Smooth |
| 4 | 2-Pyrazine carboxylic acid | 127 | Good Smooth |
| 5 | Tetramethyl-pyrazine | 102 | Good |
| 6 | 2-Quinoxalinol | 95 | Good |
| A | Phthalazine | 80 | Dull |
| B | Phenazine | 55 | - |
| C | 3,4,5-Trichloro-pyridazine | 55 | Good |
| D | 1,2,4-Triazole | 65 | Good |
| E | 1-Phenyl-1H-tetrazole-5-thiol | 45 | Very Smooth |
| F | 3,6-Dihydroxy-pyridazine | 40 | - |
| G | None | 35 | - |
| H | Guanazole | 35 | - |
| I | 1(2H)-Phthalazinone | 35 | - |
| J | 29H,31H-Phthalocyanine | 35 | - |
| K | 1,10-Phenanthroline | 15 | - |

EXAMPLE 7

A 10 liter reaction vessel with magnetic stir bar was charged with 1150 g of gallic acid, 1650 ml of deionized water, 3650 ml of ethanolamine, 25 g of catalyst (2,3-pyrazinedicarboxamide), and 3 ml of surfactant (10% of "FC-129", a commercial product of 3M Corp.). The stirred mixture was heated to reflux (115°C) under a water condenser. Silicon wafers having a (100) crystallographic orientation were etched by immersing the wafers in the stirred, refluxing etching solution using a PTFE wafer boat. The etch rates of these wafers, determined by weight loss, was 116 μ/hr. as summarized in Table II below.

EXAMPLES 8-19 AND COMPARATIVE EXAMPLES L-S

The procedure of Example 7 was repeated, but by systematically varying the concentrations of the ingredients using the formulations as shown in Table II below. In each Comparative Example, the etch rate results for (100) silicon were found to be unacceptable. The results of these Examples and Comparative Examples are also summarized in Table II below.

TABLE II
(100) SILICON ETCH RATE OF VARIOUS ETCHANT FORMULATIONS AT REFLUX

| Example (No.) Or Comparative Example (Letter) | Catalyst | Gallic Acid (Mole %) | Water (Mole %) | Amine (Mole %) | Rate (μ/HR) | Surface Quality |
|---|---|---|---|---|---|---|
| L | 2,3-Pyrazine-dicarboxamide | 1.91 | 51.96 | 46.00 | 37 | White Precipitate |
| 7 | 2,3-Pyrazine-dicarboxamide | 3.76 | 50.98 | 45.14 | 116 | Smooth |
| 8 | 2,3-Pyrazine-dicarboxamide | 5.53 | 49.77 | 44.30 | 106 | Smoother |
| M | 2,3-Pyrazine-dicarboxamide | 7.25 | 49.13 | 43.50 | 70 | Smoother |
| N | 2-Pyrazinecar-boxylic acid | 1.91 | 51.96 | 46.00 | 38 | White Precipitate |
| 9 | 2-Pyrazinecar-boxylic acid | 3.76 | 50.98 | 45.14 | 101 | Good |
| 10 | 2-Pyrazinecar-boxylic acid | 5.53 | 49.77 | 44.30 | 102 | Smooth |
| O | 2-Pyrazinecar-boxylic acid | 7.25 | 49.13 | 43.50 | 88 | Smooth |
| P | 2,3-Pyrazine-dicarboxamide | 5.05 | 34.21 | 60.58 | 83 | Light Precipitate |
| 11 | 2,3-Pyrazine-dicarboxamide | 3.76 | 50.98 | 45.14 | 119 | Good |
| 12 | 2,3-Pyrazine-dicarboxamide | 2.99 | 60.96 | 35.95 | 115 | Dull |
| Q | 2,3-Pyrazine-dicarboxamide | 2.49 | 67.56 | 29.90 | 75 | Rough |
| R | 2-Pyrazinecar-boxylic acid | 5.05 | 34.21 | 60.58 | 67 | Moderate Precipitate |
| 13 | 2-Pyrazinecar-boxylic acid | 3.76 | 50.98 | 45.14 | 101 | Good |
| 14 | 2-Pyrazinecar-boxylic acid | 2.99 | 60.96 | 35.95 | 129 | Very Good |
| S | 2-Pyrazinecar-boxylic acid | 2.49 | 67.56 | 29.90 | 25 | Dull Grey |

EXAMPLES 15-19 AND COMPARATIVE EXAMPLES T AND U

Silicon wafer halves were etched in a refluxing formulation comprised of 1150 g of gallic acid, 1650 ml of water, 3650 ml of ethanolamine and 3 ml of surfactant (10% of "FC-129", a commercial product of 3M

Corp.). Catalyst (2,3-pyrazine-dicarboxamide) was added in increments, and the resulting etch rate was monitored.

The results show that even small amounts (e.g., 2.5 g, which is equivalent to about 0.01 mole percent) of catalyst provide significant catalytic activity. It was also noted that the lower catalyst concentrations produce smoother surfaces. The results are summarized in Table III below.

TABLE III

| **Example Or Comparative Example No.** | **Catalyst Concentration** | | **Etch Rate (μ/hr.)** | **Comments** |
|---|---|---|---|---|
| | **(g/Total Solution)** | **(Mole %)** | | |
| T | None | None | 32 | Smooth |
| 15 | 2.5 | 0.0127 | 89 | Smooth, Polish Rings Evident |
| 16 | 6.25 | 0.0319 | 110 | Slightly Pocked |
| 17 | 12.5 | 0.0638 | 120 | Smooth |
| 18 | 18.75 | 0.0957 | 137 | Smooth |
| 19 | 25 | 0.1276 | 140 | Good, Some Roughness, Some Oxide |
| U | 37.5 | 0.1914 | 66 | Heavy Precipitate of Passivating Oxide |

**Claims**

1. A method of rapidly etching silicon, comprising contacting said silicon with an etching solution which comprises an aromatic compound having at least two adjacent hydroxyl groups and a polar functional group on the ring, an amine, water, and a catalytic amount of a substituted 1,4-diazine, said solution being effective to etch silicon at a rate in excess of about 100 microns per hour.

2. The method of claim 1, wherein said substituted 1,4-diazine includes at least one substituent which is a bulky group which provides steric hindrance.

3. The method of claim 2, wherein said substituted 1,4-diazine is unsymmetrical.

4. The method of claim 3, wherein said substituted 1,4-diazine is selected from compounds having the formulas:

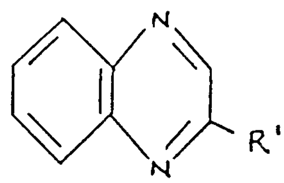

where $R^1$ is hydrogen, hydroxyl or alkyl;

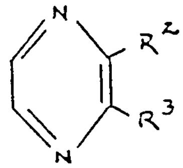

where $R^2$ is carboxyl or substituted carboxyl and $R^3$ is hydrogen, carboxyl or substituted carboxyl; or

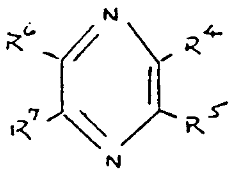

where $R_4$, $R_5$, $R_6$ and $R_7$ are independently selected from H or alkyl, where $R_4$, $R_5$, $R_6$ and $R_7$ cannot all be H.

**5.** The method of claim 4, wherein said substituted 1,4-diazine is selected from quinoxaline, 2-quinoxalinol, pyrazinamide, 2,3-pyrazinedicarboxamide, 2-pyrazine- carboxylic acid, 2,3-pyrazinedicarboxylic acid and tetramethylpyrazine.

**6.** The method of anyone of claims 1 to 5, wherein said etching solution comprises about 0.01 to about 0.15 mole percent, preferably about 0.03 to about 0.13 mole percent of said substituted 1,4-diazine.

**7.** The method of claim 1, wherein said polar functional group is COOH and said amine is selected from a diamine having 2-4 carbon atoms and an alkanolamine in which each alkanol group contains 2-3 carbon atoms.

**8.** The method of claim 7, wherein said aromatic compound is gallic acid and said amine is monoethanolamine.

**9.** A method according to anyone of claims 1 to 8, wherein said etching solution comprises about 3-6 mole percent of said aromatic compound, about 32-56 mole percent of said amine,about 65-38 mole percent of water, and a catalytic amount of said substituted 1,4-diazine, and wherein said wafer is contacted with said etching solution at a temperature greater than about 100°C to reflux.

**10.** An etching solution for rapidly etching silicon, comprising an aromatic compound having at least two adjacent hydroxyl groups and a polar functional group on the ring, an amine, water, and a catalytic amount of a substituted 1,4-diazine according to anyone of claims 1 to 9, said solution being effective to etch silicon at a rate in excess of about 100 microns per hour.

European Patent Office

# EUROPEAN SEARCH REPORT

Application Number

EP 92 11 1538

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A<br><br>A,D | EP-A-0 421 093 (IBM)<br>* claims *<br>& US-A-4 941 941 (IBM)<br>--- | 1-10 | H01L21/306<br>H01L21/321 |
| A | EP-A-0 004 872 (IBM)<br>* claims *<br>--- | 1-10 | |
| D,A | JOURNAL OF THE ELECTROCHEMICAL SOCIETY<br>vol. 126, no. 8, August 1979, MANCHESTER, NEW HAMPSHIRE US<br>pages 1406 - 1415<br>REISMAN ET AL 'The controlled etching of silicon in catalyzed Ethylenediamine-Pyrocatechol-Water solutions'<br>* abstract *<br>--- | 1-10 | |
| A | SENSORS AND ACTUATORS<br>vol. 9, no. 4, July 1986, LAUSANNE CH<br>pages 333 - 343<br>XIAN-PING WU ET AL 'A study on deep etching of silicon using ethylenediamine-pyrocatechol-water'<br>* abstract *<br>--- | 1-10 | **TECHNICAL FIELDS SEARCHED (Int. Cl.5 )**<br><br>H01L |
| A | JOURNAL OF THE ELECTROCHEMICAL SOCIETY<br>vol. 114, no. 9, September 1967, MANCHESTER, NEW HAMPSHIRE US<br>pages 965 - 970<br>FINNE ET AL 'A water-amine-complexing agent system for etching silicon'<br>* figure 5 *<br>----- | 1-10 | |

The present search report has been drawn up for all claims

| Place of search | Date of completion of the search | Examiner |
|---|---|---|
| THE HAGUE | 10 MAY 1993 | GORI |

**CATEGORY OF CITED DOCUMENTS**

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P0401)